# EUROPÄISCHE PATENTSCHRIFT

(11) **EP 0 962 546 B1**
(45) Veröffentlichungstag und Bekanntmachung des Hinweises auf die Patenterteilung: **07.03.2001**
(21) Anmeldenummer: 99108646.3
(22) Anmeldetag: 12.05.1999
(51) Int. Cl.: C23C 14/24

(54) **Elliptischer keramischer Verdampfer**
Elliptical ceramic evaporator
Evaporateur elliptique en céramique

(30) Priorität: 28.05.1998 DE 19823908
(43) Veröffentlichungstag der Anmeldung: 08.12.1999
(73) Patentinhaber: Elektroschmelzwerk Kempten GmbH, 81737 München (DE)
(72) Erfinder: Seifert, Martin, 87437 Kempten (DE)
(74) Vertreter: Potten, Holger

(56) Entgegenhaltungen:
- US-A- 2 996 412
- US-A- 4 089 643
- PATENT ABSTRACTS OF JAPAN vol. 012, no. 479 (C-552), 14. Dezember 1988 & JP 63 192860 A (HITACHI LTD), 10. August 1988

## Beschreibung

Die Erfindung betrifft keramische Verdampfer.

Das gebräuchlichste Verfahren zum Beschichten von flexiblen Substraten mit Metallen, insbesondere mit Aluminium, ist die sog. Hochvakuum-Bandbedampfung. Das zu beschichtende Substrat wird über eine gekühlte Walze geführt und dabei dem Aluminiumdampf ausgesetzt, der sich auf der Substratoberfläche als dünne Metallschicht niederschlägt.

Zur Erzeugung des erforderlichen konstanten Dampfstromes werden keramische Verdampfer, sogenannte Verdampferschiffchen, im direkten Stromdurchgang auf etwa 1450°C erhitzt. Aluminiumdraht wird kontinuierlich zugeführt, auf der Keramikoberfläche verflüssigt und bei einem Vakuum von ca. 10⁻⁴ mbar verdampft. In Metallisierungsanlagen sind eine Reihe von Verdampferschiffchen so angeordnet, daß sich über die gesamte Breite des Substrates eine gleichmäßig dicke Aluminiumschicht niederschlägt.

Die chemische Zusammensetzung der Verdampferschiffchen besteht in der Regel zu 45 - 55 Gew.% aus TiB₂, zu 25 - 55 Gew.% aus BN und zu 0 - 20 Gew.% aus AlN. Solche Zusammensetzungen sind in verschiedenen Patenten (z.B. US-A-3,915,900 oder die in US-A-4,089,643 Spalte 1, Zeilen 10 und 11 bzw. Spalte 2, Zeile 5 zitierten Patente) beschrieben.

Die übliche Form von Verdampferschiffchen geht von einem rechteckigen Querschnitt aus. Die Breite und Länge des Verdampferschiffchens werden entsprechend der erforderlichen Abdampfrate von etwa 0,35 bis 0,40 g Al cm⁻² min⁻¹ gewählt. Der rechteckige Querschnitt hat sich bewährt, weil er eine hohe mechanische Stabilität, auch bei hohen Temperaturen, und eine kostengünstige Fertigung ermöglicht.

Auch Verdampfer mit nicht rechteckigem Querschnitt sind bereits beschrieben worden. US-A- 4,089,643 beschreibt Verdampfer mit Dreiecksquerschnitt und Kavität. Als wesentliche Vorteile der Dreieckverdampfer gegenüber einem Verdampfer mit rechteckigen Querschnitt sind die Materialeinsparung und die reduzierte elektrische Leistung zum Betreiben eines solchen Verdampferschiffchens.Diesem Vorteil steht der gravierende Nachteil einer kürzeren Lebensdauer des Dreieckverdampfers im Vergleich zum Rechteckverdampfern im Betrieb gegenüber.

PATENT ABSTRACTS OF JAPAN vol. 012, no. 479 (C-552), 14. Dezember 1988 & JP 63 192 860 A offenbart einen elektrisch leitfähigen keramischen Verdampfer mit einer Zylinderteilförmigen Oberfläche (d. h. der obere Teil ist im Querschnitt Kreissegment-förmig; siehe Figuren bzw. Zusammenfassung). Der beschriebene Verdampfer dient zum Verdampfen von Al-Pellets von der Zylinderteil - förmigen Oberfläche. Ein kontinuierliches Verdampfen von Al ist mit ihm nicht möglich.

Aufgabe der Erfindung ist es einen keramischen Verdampfer zum Verdampfen von Metall zur Verfügung zu stellen, der einen im Vergleich zum Rechteckverdampfer gleicher Höhe, Länge und Breite verringerten Energieverbrauch im Betrieb zeigt, ohne mit dem Nachteil der kürzeren Lebensdauer eines Dreieckverdampfers gleicher Höhe, Länge und Breite behaftet zu sein.

Die Aufgabe wird gelöst durch einen Verdampfer, der dadurch gekennzeichnet ist, daß er im Bereich von dem die Verdampfung des Metalls erfolgt im Querschnitt die Form einer geteilten Ellipse besitzt.

Die Teilung der Ellipse ist dabei vorzugsweise entlang ihrer Hauptachse erfolgt.

Eine erfindungsgemäße Form des Verdampfers ermöglicht einen Winkel zwischen der Oberfläche von der die Verdampfung erfolgt und der elliptisch geformten Seitenwand von 90°. Dadurch kann der Verfahrensschritt des Abschleifens des spitzen Winkels in dem genannten Bereich, wie er beim Dreieckverdampfer wegen Verletzungsgefahr erforderlich ist, entfallen.

Der erfindungsgemäße Verdampfer benötigt keine spezielle Einspannvorrichtung in der Bedampfungsanlage um seitlich eingespannt zu werden, wie sie normalerweise für einen Dreieckverdampfer erforderlich ist.

Ebenso entfällt der bei Dreieckverdampfern alternativ zur speziellen Einspannung erforderliche zusätzliche Arbeitsschritt einer speziellen Bearbeitung der Enden des Verdampfers wie er z. B. in der Patentschrift: DE 197 08 599 C1 beschrieben ist

Damit ist für die Herstellung eines erfindungsgemäßen Verdampfers kein erhöhter Bearbeitungs- und Materialaufwand wie für im obigen Patent beschriebenen Dreieckverdampfer erforderlich.

Der erfindungsgemäße Verdampfer weist alle genannten Nachteile nicht auf, da er beispielsweise durch einen Schleifprozess einfach aus einem üblichen Rechteckverdampfer hergestellt werden kann.

Vorzugsweise entspricht dabei die Länge, auf der die erfindungsgemäße Form hergestellt wird, dem Einspannungsabstand des Verdampfers in der Bedampfungsanlage.

Dadurch ist es möglich, daß der erfindungsgemäße Verdampfer auf sehr einfache Weise im Bereich der Einspannung wieder einen rechteckigen Querschnitt hat und somit problemlos in Bandbedampfungsanlagen für herkömmliche Standardrechteckverdampfer betrieben werden kann.

Es ist jedoch ebenso möglich, die ganze Länge des Verdampfers in die erfindungsgemäße Form zu schleifen. Solche Verdampfer lassen sich beispielsweise in Bedampfungsanlagen mit stirnseitiger Einspannung der Verdampferschiffchen verwenden.

Bei den erfindungsgemäßen Verdampfern ist es ferner möglich auf das Einarbeiten einer Kavität zu verzichten. Selbstverständlich ist die Einarbeitung einer Kavität wie im Stand der Technik bekannt, möglich.

Fig. 1 zeigt einen Querschnittsvergleich zwischen zwei Verdampfern des Stands der Technik (Rechteckverdampfer, Dreickverdampfer) und einem erfindungsgemäßen Verdampfer (elliptischer Verdampfer). Die Verdampfer haben alle keine Kavität.

Fig. 2 zeigt schematisch ein Beispiel für einen erfindungsgemäßen Verdampfer mit Kavität, der zur stirnseitigen Einspannung geeignet ist.

Fig. 3 zeigt schematisch ein Beispiel für einen erfindungsgemäßen Verdampfer mit Kavität, der zur seitlichen Einspannung geeignet ist. Um die elliptische Form besser darzustellen, ist der Verdampfer in Fig. 3 zugleich im Schnitt dargestellt.

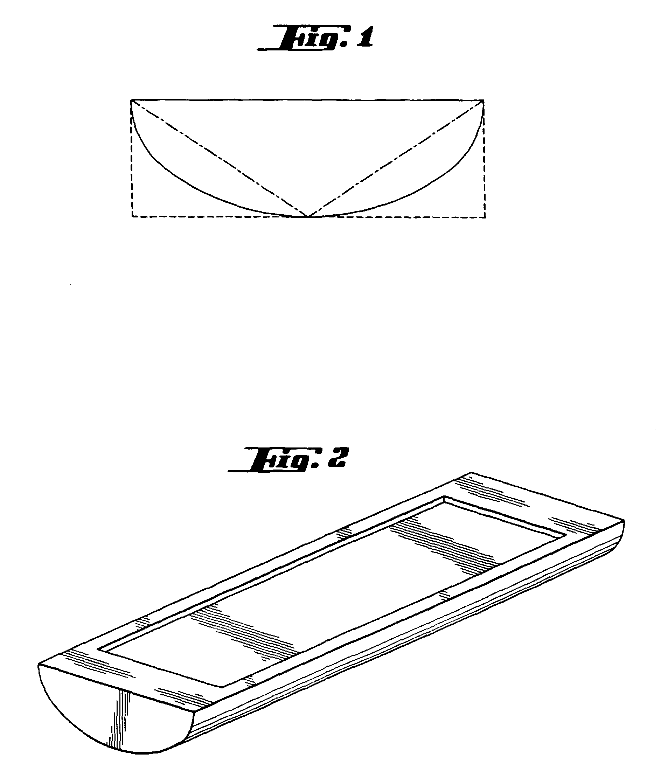

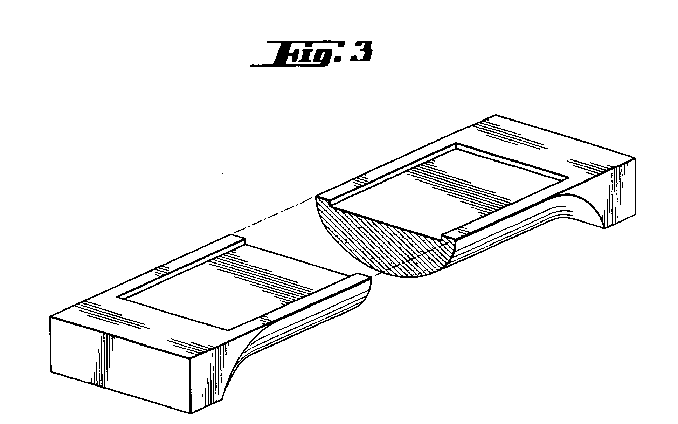

Die folgenden Beispiele dienen der weiteren Erläuterung der Erfindung.

### Beispiel 1: Herstellung eines erfindungsgemäßen Verdampfers

Aus einem Rechteckverdampfer (10*30*120 mm) käuflich erhältlich bei Elektroschmelzwerk Kempten GmbH, München (ESK) unter der Bezeichnung: DiMet Typ5 wurde mittels einer elliptisch geformten Schleifscheibe ein erfindungsgemäßer Verdampfer mit elliptischem Querschnitt herausgeschliffen.

### Beispiel 2: Vergleich zwischen Rechteck- und elliptischem Verdampfer

Es wurden ein Verdampfer gemäß Beispiel 1 sowie ein Verdampfer, der in Beispiel 1 zur Herstellung des erfindungsgemäßen Verdampfers verwendet wurde wie folgt verglichen.

Die Verdampfer wurden stirnseitig in eine Testverdampfungsanlage eingespannt. Vor dem Aufheizen wurden 2 g Al-Draht auf die Mitte der Oberfläche des Verdampferschiffchens von der die Metallverdampfung erfolgen soll gelegt. Ein Vakuum von < 1*10⁻⁴ mbar wurde angelegt. Die Verdampferschiffchen wurden in diesem Hochvakuum langsam bis zum Schmelzen des Aluminiums aufgeheizt. Zu diesem Zeitpunkt wurde die benötigte el. Leistung (Produkt von Strom und Spannung) bestimmt.

### Ergebnis:

- Rechteckiger Querschnitt:: 5.6Volt / 610Ampere = 3.42KW
- Elliptischer Querschnitt:: 5.8Volt / 525Ampere = 3.05KW

Das Ergebnis belegt, daß der Verdampfer mit elliptischem Querschnitt rund 11% weniger Energie zum Benetzen mit Aluminium braucht.

## Patentansprüche

1. Keramischer Verdampfer zum Verdampfen von Metall dadurch gekennzeichnet, daß er im Bereich von dem die Verdampfung des Metalls erfolgt im Querschnitt die Form einer halbierten Ellipse besitzt.

2. Verdampfer gemäß Anspruch 1, dadurch gekennzeichnet, daß der Querschnitt die Form einer entlang ihrer Hauptachse halbierten Ellipse besitzt.

## Claims

1. Ceramic vaporizer for the vaporization of metal, characterized in that it has a cross section in the shape of a halved ellipse in the region from which vaporization of the metal takes place.

2. Vaporizer according to Claim 1, characterized in that the cross section has the shape of an ellipse which has been halved along its principal axis.

## Revendications

1. Evaporateur en céramique pour la vaporisation d'un métal, caractérisé en ce qu'il présente une section transversale en forme d'une ellipse divisée en deux dans la région d'où la vaporisation du métal se produit.

2. Evaporateur selon la revendication 1, caractérisé en ce que la section transversale a la forme d'une ellipse divisée en deux le long de son axe principal.
